# EUROPEAN PATENT APPLICATION

(11) **EP 4 072 000 A1**
(43) Date of publication of application: **12.10.2022**
(21) Application number: 20892771.5
(22) Date of filing: 27.11.2020
(51) Int. Cl.: H02N 2/18

(54) **ENERGY CONVERSION APPARATUS, PREPARATION METHOD THEREFOR AND USE THEREOF**

(30) Priority: 29.11.2019 CN 201911199247
(71) Applicant: Luan, Yucheng, Changzhou, Jiangsu 213163 (CN)
(72) Inventor: Luan, Yucheng, Changzhou, Jiangsu 213163 (CN)
(74) Representative: Liesegang, Eva
(86) International application number: PCT/CN2020/132316
(87) International publication number: WO 2021/104464

(57) **Abstract**

The present application relates to an energy conversion apparatus. The energy conversion apparatus comprises: an upper conductive layer; a lower conductive layer, which is arranged below the upper conductive layer; and at least one piezoelectric micro/nano unit and a fluid, which are arranged between the upper conductive layer and the lower conductive layer, wherein the piezoelectric micro/nano unit has a piezoelectric property and is immersed in the fluid. The present application further relates to a preparation method for an energy conversion apparatus and the use thereof.

## Description

### CROSS REFERENCE TO RELATED APPLICATIONS

The present application claims the priority and benefit of the Chinese patent application No. 201911199247.X filed with the China National Intellectual Property Administration on November 29, 2019, the disclosure of which is incorporated herein by reference in its entirety.

### TECHNICAL FIELD

The present application relates to the field of energy. In particular, the present application relates to an energy conversion device, preparation process thereof, and use thereof.

### BACKGROUND

The main forms of energy in the world are fossil energy, nuclear energy and solar energy. However, the limitation of fossil energy, the safety in the use of nuclear energy and the difficulty of nuclear waste disposal has created a more urgent demand to seek sustainable green and pollution-free energy.

Molecular thermal motion, as a green renewable energy source, contains enormous energy. The average translational kinetic energy of molecular thermal motion of the gas molecule of, for instance, an ideal gas at room temperature (27°C) is 3.7 kJ/mol. Due to the existence of a large number of liquids and gases on the earth, even if part of the energy can be converted into electrical energy, it will have a profound impact on the energy pattern. Moreover, molecular thermal motion is a special material motion intrinsically different from ordinary mechanical motion, it follows the laws of thermodynamics, which mean that thermal motion is a random motion that never stops and does not have a destructive effect on the environment/ecology. In addition, molecular thermal motion, unlike some other energy sources, does not have many use problems mentioned above.

### SUMMARY OF THE INVENTION

In one aspect, the present application provides an energy conversion device comprising:
an upper conductive layer;
a lower conductive layer disposed beneath the upper conductive layer;
at least one piezoelectric micro-/nano-unit and a fluid disposed between the upper conductive layer and the lower conductive layer;
wherein the piezoelectric micro-/nano-unit has piezoelectric properties and is immersed in the fluid.

In some embodiments of the energy conversion device, one end of the piezoelectric micro-/nano-unit is fixed on the surface of the lower conductive layer facing the upper conductive layer, and the other end of the piezoelectric micro-/nano-unit is in contact with the upper conductive layer. In some embodiments, the upper conductive layer covers onto the surface of the lower conductive layer on which the piezoelectric micro-/nano-unit is fixed. In some embodiments, the piezoelectric micro-/nano-unit comprises or is composed of a piezoelectric micro-/nano-material selected from the group consisting of hexagonal wurtzite piezoelectric materials, perovskite-type piezoelectric materials, polymer piezoelectric materials, and combinations thereof.

In other embodiments of the energy conversion device, the energy conversion device further comprises at least one additional micro-/nano-unit, one end of the piezoelectric micro-/nano-unit is fixed on the surface of the lower conductive layer facing the upper conductive layer, one end of the additional micro-/nano-unit is fixed on the surface of the upper conductive layer facing the lower conductive layer, and the other end of the piezoelectric micro-/nano-unit is a free end such that the piezoelectric micro-/nano-unit, when randomly vibrating, may contact with the additional micro-/nano-unit; wherein the other end of the additional micro/nano unit is optionally a free end;
wherein the additional micro-/nano-unit satisfies at least one of the following conditions (i) and (ii):
(i) the additional micro-/nano-unit comprises or is composed of a material capable of forming a Schottky junction or heterojunction with the piezoelectric micro-/nano-unit;
(ii) the surfaces of the additional micro-/nano-unit is coated with a shell material which is a material capable of forming a Schottky junction or a heterojunction with the piezoelectric micro-/nano-unit.

In some embodiments, the piezoelectric micro-/nano-units on the surface of the lower conductive layer form a cross-finger structure with the additional micro-/nano-units on the surface of the upper conductive layer.

In some embodiments, the micro-/nano-material in the additional micro-/nano-unit is the same as or different from the piezoelectric micro-/nano-material in the piezoelectric micro-/nano-unit.

In some embodiments, when the micro-/nano-material in the additional micro-/nano-unit is the same as the piezoelectric micro-/nano-material in the piezoelectric micro-/nano-unit, the surfaces of the additional micro-/nano-unit is coated with the shell material.

In some embodiments, the additional micro-/nano-unit is a non-piezoelectric micro-/nano-unit.

In some embodiments, the piezoelectric micro-/nano-unit comprise or is composed of a piezoelectric semiconductor micro-/nano-material.

In still further embodiments of the energy conversion device, wherein the at least one piezoelectric micro-/nano-unit refers to two or more piezoelectric micro-/nano-units, the two surfaces of the upper and the lower conductive layers opposite to each other are fixed with one ends of the piezoelectric micro-/nano-units, and the other end of each of the piezoelectric micro-/nano-units on at least one of said two surfaces of the upper and lower conductive layers is a free end such that the piezoelectric micro-/nano-units having the free end on the at least one of the conductive layers, when randomly vibrating, may contact with the piezoelectric micro-/nano-units on the opposite other conductive layer;
wherein the surfaces of the piezoelectric micro-/nano-units on the surface of the upper conductive layer or the surfaces of the piezoelectric micro-/nano-units on the surface of the lower conductive layer are coated with a shell material which is a material capable of forming a Schottky junction or a heterojunction with the piezoelectric micro-/nano-units.

In some embodiments, the piezoelectric micro-/nano-units on the surface of the upper conductive layer form a cross-finger structure with the piezoelectric micro-/nano-units on the surface of the lower conductive layer.

In some embodiments, the piezoelectric micro-/nano-units comprise or are composed of a piezoelectric semiconductor micro-/nano-material.

In another aspect, the present application provides a method for manufacturing an energy conversion device, comprising:
providing an upper conductive layer;
providing a lower conductive layer and disposing it beneath the upper conductive layer;
disposing at least one piezoelectric micro-/nano-unit and a fluid between the upper conductive layer and the lower conductive layer; and
immersing the piezoelectric micro-/nano-unit in the fluid.

In some embodiments of the method, the method further comprises:
a fixing step: fixing one end of the piezoelectric micro-/nano-unit on a surface of the lower conductive layer; in some embodiments, the fixing step comprises growing the piezoelectric micro-/nano-unit on the surface of the lower conductive layer; in some embodiments, said growth refers to growing along an orientation perpendicular to the surface of the conductive layer;
an assembling step: contacting the other end of the fixed piezoelectric micro-/nano-unit with the upper conductive layer; in some embodiments, the assembling step comprises covering the upper conductive layer onto the surface of the lower conductive layer on which the piezoelectric micro-/nano-unit is grown;
a fluid introducing step: introducing the fluid optionally before, after or during the assembling step; in some embodiments, the fluid introducing step comprises introducing the fluid to the surface of the lower conductive layer on which the piezoelectric micro-/nano-unit is fixed before the assembling step; in some embodiments, the fluid introducing step comprises introducing the fluid between the upper conductive layer and the lower conductive layer after the assembling step; in some embodiments, the fluid introducing step comprises conducting the assembly step in an atmosphere of the fluid as a gas to introduce the fluid during the assembling process; in some embodiments, the fluid introducing step comprises introducing the liquid between the upper conductive layer and the lower conductive layer after the assembling step;

In some embodiments, the method further comprises a device encapsulation step; in some embodiments, the device encapsulation step comprises physical or chemical encapsulation, and in some embodiments, the encapsulation is a mechanical encapsulation, or encapsulation using an adhesive or tape.

In some embodiments, the piezoelectric micro-/nano-unit comprises or is composed of a piezoelectric micro-/nano-material selected from the group consisting of hexagonal wurtzite piezoelectric materials, perovskite-type piezoelectric materials, polymer piezoelectric materials, and combinations thereof.

In some embodiments, when the piezoelectric micro-/nano-unit comprises a piezoelectric micro-/nano-material selected from the group consisting of perovskite-type piezoelectric materials, polymer piezoelectric materials, and combinations thereof, polarizing the device before the fluid introducing step; in some embodiments, the polarizing step comprises applying an electric field between the upper conductive layer and the lower conductive layer to spontaneously polarize the device under the electric field such that the piezoelectric micro-/nano-unit is preferentially oriented along the direction of the electric field.

In other embodiments of the method, wherein the device further comprises an additional micro-/nano-unit, wherein the additional micro-/nano-unit satisfies at least one of the following conditions (i) and (ii):
(i) the additional micro-/nano-unit comprises or is composed of a material capable of forming a Schottky junction or heterojunction with the piezoelectric micro-/nano-unit;
(ii) the surfaces of the additional micro-/nano-unit is coated with a shell material which is a material capable of forming a Schottky junction or a heterojunction with the piezoelectric micro-/nano-unit.

The method further comprises:
a fixing step: fixing one end of the piezoelectric micro-/nano-unit on the surface of the lower conductive layer, and fixing one end of the additional micro-/nano-unit on the surface of the upper conductive layer, and the other end of the piezoelectric micro-/nano-unit is a free end, the other end of the additional micro-/nano-unit is optionally a free end; in some embodiments, the fixing step comprises growing the additional micro-/nano-unit and the piezoelectric micro-/nano-unit on the surface of the upper conductive layer and the surface of the lower conductive layer, respectively; in some embodiments, said growth refers to growing along an orientation perpendicular to the surface of the conductive layer;
an optional coating step: coating the shell material on the surface of the additional micro-/nano-unit when the additional micro-/nano-unit does not satisfy the above condition (i); wherein the shell material is a material capable of forming a Schottky junction or a heterojunction with the piezoelectric micro-/nano-unit;
an assembling step: assembling in such a manner that the surface of the lower conductive layer on which the piezoelectric micro-/nano-unit is fixed and the surface of the upper conductive layer on which the additional micro-/nano-unit is fixed face each other, so that the piezoelectric micro-/nano-unit, when randomly vibrating, may contact with the additional micro-/nano-unit; wherein when the additional micro/nano cell does not satisfy the above condition (i), the upper conductive layer on which the additional micro-/nano-unit is fixed is the upper conductive layer on which the additional micro-/nano-unit coated with the shell material is fixed;

In some embodiments, the assembling step comprises: disposing peripherally a spacer on the surface of the lower conductive layer on which the piezoelectric micro-/nano-unit is fixed, wherein the thickness of the spacer or the thickness of the compressed spacer when the spacer is compressed due to a force is not less than the distance from the free end of the piezoelectric micro-/nano-unit to the surface of the lower conductive layer on which the piezoelectric micro-/nano-unit is fixed, and less than the sum of the distance from the free end of the piezoelectric micro-/nano-unit to the surface of the lower conductive layer on which the piezoelectric micro-/nano-unit is fixed and the distance from the free end of the additional micro-/nano-unit to the surface of the upper conductive layer on which the additional micro-/nano-unit is fixed; and placing the upper conductive layer, on which the additional micro/nano unit is fixed, on the spacer;
a fluid introducing step: introducing the fluid optionally before or during the assembling step step; in some embodiments, the fluid introducing step comprises introducing the fluid to the surface of the lower conductive layer on which the piezoelectric micro-/nano-unit is fixed and the surface of the upper conductive layer on which the additional micro-/nano-unit is fixed before the assembling step; in some embodiments, the fluid introducing step comprises introducing the fluid as a liquid into the space surrounded by the entire spacer after disposing the spacer, and then placing the upper conductive layer on which the additional micro-/nano-unit is fixed on the spacer to introduce the fluid during the assembling process; wherein when the additional micro-/nano-unit does not satisfy the above condition (i), the surface of the upper conductive layer on which the additional micro-/nano-unit is fixed is the surface of the upper conductive layer on which the additional micro-/nano-unit coated with the shell material is fixed; in some embodiments, the fluid introducing step comprises conducting the assembling step in an atmosphere of the fluid as a gas to introduce the fluid during the assembling process.

In some embodiments, the method further comprises a device encapsulation step; in some embodiments, the device encapsulation step comprises physical or chemical encapsulation, and in some embodiments, the encapsulation is a mechanical encapsulation, or encapsulation using an adhesive or tape.

In some embodiments, the assembling is performed in such a manner that the additional micro-/nano-units on the surface of the upper conductive layer form a cross-finger structure with the piezoelectric micro-/nano-units on the surface of the lower conductive layer.

In some embodiments, the micro-/nano-material in the additional micro-/nano-unit is the same as or different from the piezoelectric micro-/nano-material in the piezoelectric micro-/nano-unit.

In some embodiments, when the micro-/nano-material in the additional micro-/nano-unit is the same as the piezoelectric micro-/nano-material in the piezoelectric micro-/nano-unit, the surfaces of the additional micro-/nano-unit is coated with the shell material.

In some embodiments, the additional micro-/nano-unit is a non-piezoelectric micro-/nano-unit.

In some embodiments, the piezoelectric micro-/nano-unit comprise or is composed of a piezoelectric semiconductor micro-/nano-material.

In some embodiments of any of the preceding aspects, wherein the two surfaces of the upper and lower conductive layers opposite each other are substantially parallel.

In some embodiments of any of the preceding aspects, the micro-/nano-unit at each occurrence is a micro/nanometer array.

In some embodiments of any of the preceding aspects, the piezoelectric micro-/nano-unit and the additional micro-/nano-unit are each at least partially or completely immersed in the fluid.

In some embodiments of any of the preceding aspects, the space between the two surfaces of the upper and lower conductive layers opposite each other is at least partially or completely filled with the fluid.

In some embodiments of any of the preceding aspects, the fixing refers to fixing along an orientation perpendicular to the surface of the conductive layer.

In some embodiments of any of the preceding aspects, the energy conversion device further comprises an encapsulation layer; the encapsulation layer is provided on the outer periphery of the device. In some embodiments of any of the preceding aspects, the encapsulation layer comprises an adhesive. In some embodiments of any of the preceding aspects, the adhesive is selected from the group consisting of epoxy resins, silicones, EVA, and combinations thereof.

In some embodiments of any of the preceding aspects, the energy conversion device further comprises lead wires; the lead wires are led out from the upper conductive layer and the lower conductive layer respectively.

In some embodiments of any of the preceding aspects, the fluid is a gas or a liquid.

In some embodiments of any of the preceding aspects, the gas is a compressed and/or warmed gas.

In some embodiments of any of the preceding aspects, the gas is a heavy molecular gas. In some embodiments of any of the preceding aspects, the gas is a compressed and/or warmed heavy molecular gas.

In some embodiments of any of the preceding aspects, the gas is air, compressed air, xenon, oxygen, nitrogen, hydrogen, and combinations thereof.

In some embodiments of any of the preceding aspects, the fluid is a warmed liquid.

In some embodiments of any of the preceding aspects, the dielectric constant of the liquid is less than 80, less than 40, less than 10, less than 4.0, less than 3.0, less than 2.5, or less than 2.0.

In some embodiments of any of the preceding aspects, the viscosity of the liquid is less than 80000 mPa·s, less than 8000 mPa·s, less than 800 mPa·s, less than 80 mPa·s, less than 8 mPa·s, or less than 0.8 mPa·s.

In some embodiments of any of the preceding aspects, the liquid is a non-polar or weakly polar liquid.

In some embodiments of any of the preceding aspects, the liquid is a low viscosity liquid.

In some embodiments of any of the preceding aspects, the liquid is a non-polar or weakly polar and low viscosity liquid.

In some embodiments of any of the preceding aspects, the liquid is selected from the group consisting of dimethyl carbonate, diethyl carbonate, tetrachloroethylene, cyclopentene, n-octane, n-hexane, ethanol, dichloroethane, and combinations thereof.

In some embodiments of any of the preceding aspects, the upper conductive layer and the lower conductive layer comprise a conductive or non-conductive substrate; in some embodiments, the upper conductive layer and the lower conductive layer each independently comprise a material selected from the group consisting of a metal, a carbon material, a semiconductor material, and combinations thereof; in some embodiments, the upper conductive layer and the lower conductive layer each independently comprise a material selected from the group consisting of Au, Pt, Ag, Cu, Zn, ITO, FTO, C, and combinations thereof.

In some embodiments of any of the preceding aspects, the structures of the upper conductive layer and the lower conductive layer are each independently a nanostructure which is flake or coated with a conductive film layer. In some embodiments of any of the preceding aspects, the nanostructure is a nanogroove, a nanoarray, or a combination thereof.

In some embodiments of any of the preceding aspects, the minimum radial dimension of at least a portion of the cross-section of each of the nano-units in the direction of extension thereof is 1nm-10µm, 10nm-1µm, 20nm-300nm, 10nm-500nm, or 10nm-100nm.

In some embodiments of any of the preceding aspects, the gap between the nano-units in the nano-array is 5nm-20µm, 20nm-5µm, 50nm-1µm, 80nm-500nm, or 100nm-300nm.

In some embodiments of any of the preceding aspects, the piezoelectric micro-/nano-units and the additional micro-/nano-units are each independently nanorods, nanosheets, nanowires, nanobelts, nanotubes, nanohelices, or combinations thereof.

In some embodiments of any of the preceding aspects, the piezoelectric semiconductor micro-/nano-material is selected from hexagonal wurtzite piezoelectric materials.

In some embodiments of any of the preceding aspects, the hexagonal wurtzite piezoelectric materials are selected from the group consisting of ZnO, GaN, ZnS, CdS, InN, InGaN, CdTe, CdSe, ZnSnO3, and combinations thereof.

In some embodiments of any of the preceding aspects, the perovskite-type piezoelectric materials have a general Formula of ABO₃; wherein A is a rare earth or alkaline earth metal ion, and B is a transition metal ion.

In some embodiments of any of the preceding aspects, the perovskite-type piezoelectric materials are selected from the group consisting of lead zirconate titanate PZT, barium titanate BaTiO₃, potassium sodium niobate KNN, and combinations thereof.

In some embodiments of any of the preceding aspects, the polymer piezoelectric materials are selected from the group consisting of polyvinylidene fluoride PVDF, and polydimethylsiloxane PDMS.

In some embodiments of any of the preceding aspects, the piezoelectric micro-/nano-unit is a ZnO nano-array.

In some embodiments of any of the preceding aspects, the shell material is a metal material having a work function value greater than or less than the work function value of the piezoelectric semiconductor micro-/nano-material.

In some embodiments of any of the preceding aspects, the shell material is other semiconductor material capable of forming a heterojunction with the piezoelectric semiconductor micro-/nano-material.

In some embodiments of any of the preceding aspects, the shell material is a metal material selected from the group consisting of Au, Pt, Ag, Ti, Al, and combinations thereof.

In some embodiments of any of the preceding aspects, the shell material is a semiconductor material selected from the group consisting of CuO, silicon wafer, Cu₂O, NiO, CO₃O₄, and combinations thereof.

In some embodiments of any of the preceding aspects, the shell material is formed by magnetron sputtering, electron beam evaporation, thermal evaporation, or sol-gel of the shell material on the surface of the upper conductive layer on which the nano-units are fixed.

In yet another aspect, the present application provides an article, apparatus, or power supply device comprising the energy conversion device of the present disclosure. In some embodiments, the article or apparatus is powered by the energy conversion device.

In still another aspect, the present application provides use of the energy conversion device of the present disclosure in energy conversion and collection, for example, energy storage, sensors, wearable devices, and mobile devices.

### BRIEF DESCRIPTION OF THE DRAWINGS

Figure 1 is a schematic structural diagram of the energy conversion device of Example 1.
Figure 2 shows the current-voltage curve of the energy conversion device of Example 1.
Figure 3 shows the voltage and current outputs of the energy conversion device of Example 1.
Figure 4 shows the current and voltage output curves of the energy conversion device of Example 2.
Figure 5 shows the cyclic voltammetry curve of the energy conversion device of Example 2.
Figure 6 shows the current and voltage output curves of the energy conversion device of Example 3.
Figure 7 is a schematic structural diagram of the energy conversion device of Example 4.
Figure 8 shows the voltage and current outputs of the energy conversion device of Example 5 at different temperatures.

### DETAILED DESCRIPTION

### Definition

The following definitions and methods are provided to better define the prsent application and to guide those of ordinary skill in the art in the practice of the present application. Unless otherwise indicated, the terms are to be understood in accordance with conventional usage by one of ordinary skill in the relevant art.

As used herein, the terms "comprises" and "comprising" are to be interpreted as being inclusive and open-ended, and not exclusive. In particular, when used in the specification and claims, the terms "comprises" and "comprising" and variations thereof are intended to include the specified features, steps, or components. These terms should not be interpreted as excluding the presence of other features, steps, or components.

The term "optional" or "optionally" used herein means that the subsequently described event or circumstance may but need not occur, and that the description includes instances where the event or circumstance occurs and instances in which it does not. It represents an option and can be used interchangeably with "or".

Spatially relative terms, such as "below" "beneath" "lower" "above","upper", "over" or the like, may be used herein for descriptive purposes and thus to describe the relations between one element and another element as illustrated in the drawings. The spatially relative terms are intended to encompass different orientations of the device in use, operation and/or manufacture in addition to the orientation depicted in the drawings. For example, in the case where a device illustrated in the drawing is turned over, the element positioned "above" or "over" another element or feature may be oriented "below" another element or feature. Accordingly, the illustrative term "above" may include both the lower and upper positions. Moreover, the device may also be oriented in other directions (e.g, rotated 90 degrees or at other directions) and as such, the spatially relative descriptors used herein are interpreted accordingly.

The term "polymer piezoelectric material" used herein generally refers to some piezoelectric materials composed of macromolecule polymers.

The term "micro-/nano-unit" used herein refers to a micro-unit, a nano-unit, or a combination thereof.

The term "heavy molecular gas" used herein refers to a gas having a relative molecular weight of not less than 25 (e.g., not less than 25, not less than 40, not less than 60, not less than 80, or not less than 100).

Where a range of numerical values is recited or established herein, the range includes the endpoints thereof and all the individual integers and fractions within the range, and also includes each of the narrower ranges therein formed by all the various possible combinations of those endpoints and internal integers and fractions to form subgroups of the larger group of values within the stated range to the same extent as if each of those narrower ranges was explicitly recited. For example, the expression that the minimum radial dimension of at least a portion of the cross-section of each of the nano-units in the direction of extension thereof is 1nm-10µm means that said minimum radial dimension may be, for example, 1nm, 2nm, 3nm, 4nm, 5nm, 6nm, 7nm, 8nm, 9nm, 10nm, 11nm, 12nm, 13nm, 14nm, 15nm, 16nm, 17nm, 18nm, 19nm, 20nm, 21nm, 22 nm, 24 nm, 28 nm, 30 nm, 32 nm, 35 nm, 38 nm, 40 nm, 50 nm, 60 nm, 70 nm, 80 nm, 90 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 400 nm, 500 nm, 600 nm, 700 nm, 800 nm, 900 nm, 1µm, 2µm, 3µm, 4µm, 5µm, 6µm, 7µm, 8µm, 9µm, or 10µm etc., and ranges therebetween.

In one aspect, the present application provides an energy conversion device comprising:
an upper conductive layer;
a lower conductive layer disposed beneath the upper conductive layer;
at least one piezoelectric micro-/nano-unit and a fluid disposed between the upper conductive layer and the lower conductive layer;
wherein the piezoelectric micro-/nano-unit has piezoelectric properties and is immersed in the fluid.

The basic principle of the energy conversion device of the present invention is that when a piezoelectric material with piezoelectric effect is placed in a fluid, due to molecular thermal motion of the fluid, the piezoelectric material undergoes a Brownian motion, vibrates randomly, and is deformed, thereby generating a potential difference on the surface of the material, which is then led out through an electrode and form a detectable current in an external circuit. The potential difference of the piezoelectric material is derived at least in part from the molecular thermal motion. The piezoelectric material may include various piezoelectric materials in the art capable of producing a piezoelectric effect, including but not limited to one of hexagonal wurtzite piezoelectric materials, perovskite-type piezoelectric materials, polymer piezoelectric materials, and combinations thereof.

In some embodiments of the energy conversion device, one end of the piezoelectric micro-/nano-unit is fixed on the surface of the lower conductive layer facing the upper conductive layer, and the other end of the piezoelectric micro-/nano-unit is in contact with the upper conductive layer. In some embodiments, the upper conductive layer covers onto the surface of the lower conductive layer on which the piezoelectric micro-/nano-unit is fixed. In some embodiments, the piezoelectric micro-/nano-unit comprises or is composed of a piezoelectric micro-/nano-material selected from the group consisting of hexagonal wurtzite piezoelectric materials, perovskite-type piezoelectric materials, polymer piezoelectric materials, and combinations thereof.

The upper conductive layer (e.g., an aluminum foil) covered onto the surface of the lower conductive layer on which the piezoelectric micro-/nano-unit is fixed, may be directly used as an upper electrode or combined with other electrode materials as an upper electrode. The lower conductive layer (e.g., FTO conductive surface) may be directly used as a lower electrode. The upper electrode and the lower electrode are respectively led out by lead wires (e.g., copper wires) to form a detectable current in the external circuit.

In other embodiments of the energy conversion device, the energy conversion device further comprises at least one additional micro-/nano-unit, one end of the piezoelectric micro-/nano-unit is fixed on the surface of the lower conductive layer facing the upper conductive layer, one end of the additional micro-/nano-unit is fixed on the surface of the upper conductive layer facing the lower conductive layer, and the other end of the piezoelectric micro-/nano-unit is a free end such that the piezoelectric micro-/nano-unit, when randomly vibrating, may contact with the additional micro-/nano-unit; wherein the other end of the additional micro/nano unit is optionally a free end;
wherein the additional micro-/nano-unit satisfies at least one of the following conditions (i) and (ii):
(i) the additional micro-/nano-unit comprises or is composed of a material capable of forming a Schottky junction or heterojunction with the piezoelectric micro-/nano-unit;
(ii) the surfaces of the additional micro-/nano-unit is coated with a shell material which is a material capable of forming a Schottky junction or a heterojunction with the piezoelectric micro-/nano-unit.

In some embodiments, the piezoelectric micro-/nano-units on the surface of the lower conductive layer form a cross-finger structure with the additional micro-/nano-units on the surface of the upper conductive layer.

In some embodiments, the micro-/nano-material in the additional micro-/nano-unit is the same as or different from the piezoelectric micro-/nano-material in the piezoelectric micro-/nano-unit.

In some embodiments, when the micro-/nano-material in the additional micro-/nano-unit is the same as the piezoelectric micro-/nano-material in the piezoelectric micro-/nano-unit, the surfaces of the additional micro-/nano-unit is coated with the shell material.

In some embodiments, the additional micro-/nano-unit is a non-piezoelectric micro-/nano-unit.

In some embodiments, the piezoelectric micro-/nano-unit comprise or is composed of a piezoelectric semiconductor micro-/nano-material.

The shell material may be directly used as the upper electrode, and the lower conductive layer (for example, a metal substrate, such as a Zn sheet) may be directly used as the lower electrode. The upper and lower electrodes are led out by lead wires to form a detectable current in the external circuit.

In still further embodiments of the energy conversion device, wherein the at least one piezoelectric micro-/nano-unit refers to two or more piezoelectric micro-/nano-units, the two surfaces of the upper and the lower conductive layers opposite to each other are fixed with one ends of the piezoelectric micro-/nano-units (namely, one end of some of the piezoelectric micro-/nano-units is fixed on the upper conductive layer, and one end of the remaining piezoelectric micro-/nano-units is fixed on the surface of the lower conductive layer facing the upper conductive layer), and the other end of each of the piezoelectric micro-/nano-units on at least one of said two surfaces of the upper and lower conductive layers is a free end such that the piezoelectric micro-/nano-units having the free end on the at least one of the conductive layers, when randomly vibrating, may contact with the piezoelectric micro-/nano-units on the opposite other conductive layer;
wherein the surfaces of the piezoelectric micro-/nano-units on the surface of the upper conductive layer or the surfaces of the piezoelectric micro-/nano-units on the surface of the lower conductive layer are coated with a shell material which is a material capable of forming a Schottky junction (for example, metal shell materials) or a heterojunction (for example, shell materials such as CuO, silicon wafer, Cu₂O, NiO, Co₃O₄, etc.) with the piezoelectric micro-/nano-units.

In some embodiments, the piezoelectric micro-/nano-units on the surface of the upper conductive layer form a cross-finger structure with the piezoelectric micro-/nano-units on the surface of the lower conductive layer.

In some embodiments, the piezoelectric micro-/nano-units comprise or are composed of a piezoelectric semiconductor micro-/nano-material.

The shell material may be directly used as the upper electrode, and the lower conductive layer (for example, a metal substrate sheet such as a Zn sheet) may be directly used as the lower electrode. The upper and lower electrodes are respectively led out by lead wires, and the potential difference generated by the semiconductor piezoelectric material is passed through the upper electrode, and unidirectional DC output is realized by utilizing the unidirectional conducting rectification characteristic of the Schottky junction at the interface between the metal and the semiconductor or the PN junction between the semiconductors.

In some embodiments, the lower conductive layer (e.g., a metal substrate) is polished.

In another aspect, the present application provides a method for manufacturing an energy conversion device, comprising:
providing an upper conductive layer;
providing a lower conductive layer and disposing it beneath the upper conductive layer;
disposing at least one piezoelectric micro-/nano-unit and a fluid between the upper conductive layer and the lower conductive layer; and
immersing the piezoelectric micro-/nano-unit in the fluid.

In some embodiments of the method, the method further comprises:
a fixing step: fixing one end of the piezoelectric micro-/nano-unit on a surface of the lower conductive layer; in some embodiments, the fixing step comprises growing the piezoelectric micro-/nano-unit on the surface of the lower conductive layer; in some embodiments, said growth refers to growing along an orientation perpendicular to the surface of the conductive layer;
an assembling step: contacting the other end of the fixed piezoelectric micro-/nano-unit with the upper conductive layer; in some embodiments, the assembling step comprises covering the upper conductive layer onto the surface of the lower conductive layer on which the piezoelectric micro-/nano-unit is grown;
a fluid introducing step: the fluid may be introduced optionally before, after or during the assembling step; in some embodiments, the fluid introducing step comprises introducing the fluid to the surface of the lower conductive layer on which the piezoelectric micro-/nano-unit is fixed before the assembling step; in some embodiments, the fluid introducing step comprises introducing the fluid between the upper conductive layer and the lower conductive layer after the assembling step; in some embodiments, the fluid introducing step comprises conducting the assembly step in an atmosphere of the fluid as a gas to introduce the fluid during the assembling process; in some embodiments, the fluid introducing step comprises introducing (e.g., dropwise adding) the liquid between the upper conductive layer and the lower conductive layer after the assembling step;

In some embodiments, the method may further comprise a device encapsulation step; in some embodiments, the device encapsulation step comprises physical or chemical encapsulation, and in some embodiments, the encapsulation is a mechanical encapsulation, or encapsulation using an adhesive or tape.

In some embodiments, the piezoelectric micro-/nano-unit may comprise or be composed of a piezoelectric micro-/nano-material selected from the group consisting of hexagonal wurtzite piezoelectric materials, perovskite-type piezoelectric materials, polymer piezoelectric materials, and combinations thereof.

In some embodiments, when the piezoelectric micro-/nano-unit comprises a piezoelectric micro-/nano-material selected from the group consisting of perovskite-type piezoelectric materials, polymer piezoelectric materials, and combinations thereof, polarizing the device before the fluid introducing step; in some embodiments, the polarizing step comprises applying an electric field between the upper conductive layer and the lower conductive layer to spontaneously polarize the device under the electric field such that the piezoelectric micro-/nano-unit is preferentially oriented along the direction of the electric field.

In other embodiments of the method, wherein the device further comprises an additional micro-/nano-unit, wherein the additional micro-/nano-unit satisfies at least one of the following conditions (i) and (ii):
(i) the additional micro-/nano-unit comprises or is composed of a material capable of forming a Schottky junction or heterojunction with the piezoelectric micro-/nano-unit;
(ii) the surfaces of the additional micro-/nano-unit is coated with a shell material which is a material capable of forming a Schottky junction or a heterojunction with the piezoelectric micro-/nano-unit.

The method further comprises:
a fixing step: fixing one end of the piezoelectric micro-/nano-unit on the surface of the lower conductive layer, and fixing one end of the additional micro-/nano-unit on the surface of the upper conductive layer, and the other end of the piezoelectric micro-/nano-unit is a free end, the other end of the additional micro-/nano-unit is optionally a free end, for example, the other end of the additional micro-/nano-unit may or may not be a free end (for example, may be in contact with the upper conductive layer); in some embodiments, the fixing step comprises growing the additional micro-/nano-unit and the piezoelectric micro-/nano-unit on the surface of the upper conductive layer and the surface of the lower conductive layer, respectively; in some embodiments, said growth refers to growing along an orientation perpendicular to the surface of the conductive layer;
an optional coating step: coating the shell material on the surface of the additional micro-/nano-unit when the additional micro-/nano-unit does not satisfy the above condition (i); wherein the shell material is a material capable of forming a Schottky junction or a heterojunction with the piezoelectric micro-/nano-unit;
an assembling step: assembling in such a manner that the surface of the lower conductive layer on which the piezoelectric micro-/nano-unit is fixed and the surface of the upper conductive layer on which the additional micro-/nano-unit is fixed face each other, so that the piezoelectric micro-/nano-unit, when randomly vibrating, may contact with the additional micro-/nano-unit; wherein when the additional micro/nano cell does not satisfy the above condition (i), the upper conductive layer on which the additional micro-/nano-unit is fixed is the upper conductive layer on which the additional micro-/nano-unit coated with the shell material is fixed;

In some embodiments, the assembling step comprises: disposing peripherally a spacer on the surface of the lower conductive layer on which the piezoelectric micro-/nano-unit is fixed, wherein the thickness of the spacer or the thickness of the compressed spacer when the spacer is compressed due to a force is not less than the distance from the free end of the piezoelectric micro-/nano-unit to the surface of the lower conductive layer on which the piezoelectric micro-/nano-unit is fixed, and less than the sum of the distance from the free end of the piezoelectric micro-/nano-unit to the surface of the lower conductive layer on which the piezoelectric micro-/nano-unit is fixed and the distance from the free end of the additional micro-/nano-unit to the surface of the upper conductive layer on which the additional micro-/nano-unit is fixed; and placing the upper conductive layer, on which the additional micro/nano unit is fixed, on the spacer;
a fluid introducing step: introducing the fluid optionally before or during the assembling step step; in some embodiments, the fluid introducing step comprises introducing the fluid to the surface of the lower conductive layer on which the piezoelectric micro-/nano-unit is fixed and the surface of the upper conductive layer on which the additional micro-/nano-unit is fixed before the assembling step; in some embodiments, the fluid introducing step comprises introducing the fluid as a liquid into the space surrounded by the entire spacer after disposing the spacer, and then placing the upper conductive layer on which the additional micro-/nano-unit is fixed on the spacer to introduce the fluid during the assembling process; wherein when the additional micro-/nano-unit does not satisfy the above condition (i), the surface of the upper conductive layer on which the additional micro-/nano-unit is fixed is the surface of the upper conductive layer on which the additional micro-/nano-unit coated with the shell material is fixed; in some embodiments, the fluid introducing step comprises conducting the assembling step in an atmosphere of the fluid as a gas to introduce the fluid during the assembling process.

In some embodiments, the method further comprises a device encapsulation step; in some embodiments, the device encapsulation step comprises physical or chemical encapsulation, and in some embodiments, the encapsulation is a mechanical encapsulation, or encapsulation using an adhesive or tape.

In some embodiments, the assembling is performed in such a manner that the additional micro-/nano-units on the surface of the upper conductive layer form a cross-finger structure with the piezoelectric micro-/nano-units on the surface of the lower conductive layer.

In some embodiments, the micro-/nano-material in the additional micro-/nano-unit is the same as or different from the piezoelectric micro-/nano-material in the piezoelectric micro-/nano-unit.

In some embodiments, when the micro-/nano-material in the additional micro-/nano-unit is the same as the piezoelectric micro-/nano-material in the piezoelectric micro-/nano-unit, the surfaces of the additional micro-/nano-unit is coated with the shell material.

In some embodiments, the additional micro-/nano-unit is a non-piezoelectric micro-/nano-unit.

In some embodiments, the piezoelectric micro-/nano-unit comprise or is composed of a piezoelectric semiconductor micro-/nano-material.

In some embodiments of any of the preceding aspects, wherein the two surfaces of the upper and lower conductive layers opposite each other are substantially parallel.

In some embodiments of any of the preceding aspects, the micro-/nano-unit at each occurrence is a micro/nanometer array. For example, the above-mentioned piezoelectric micro-/nano-units and the above-mentioned additional micro-/nano-units are both nanoarrays.

In some embodiments of any of the preceding aspects, the piezoelectric micro-/nano-unit and the additional micro-/nano-unit are each at least partially or completely immersed in the fluid.

In some embodiments of any of the preceding aspects, the space between the two surfaces of the upper and lower conductive layers opposite each other is at least partially or completely filled with the fluid.

In some embodiments of any of the preceding aspects, the fixing refers to fixing along an orientation perpendicular to the surface of the conductive layer. When one end of the piezoelectric material nanostructure is fixed on the lower conductive layer as the lower electrode of the energy conversion device and the other end is a free end, the strain at the free end becomes more sufficient when the piezoelectric material is placed in the fluid due to the fixing of one end.

In some embodiments of any of the preceding aspects, the energy conversion device further comprises an encapsulation layer; the encapsulation layer is provided on the whole outer periphery of the device. In some embodiments of any of the preceding aspects, the encapsulation layer comprises an adhesive. In some embodiments of any of the preceding aspects, the adhesive may be selected from the group consisting of epoxy resins, silicones, EVA, and combinations thereof.

In some embodiments of any of the preceding aspects, the energy conversion device further comprises lead wires; the lead wires are led out from the upper conductive layer and the lower conductive layer respectively.

In some embodiments of any of the preceding aspects, the fluid may be a gas or a liquid.

In some embodiments of any of the preceding aspects, the gas may be a compressed and/or warmed gas.

In some embodiments of any of the preceding aspects, the gas may be a heavy molecular gas. In some embodiments of any of the preceding aspects, the gas may be a compressed and/or warmed heavy molecular gas.

In some embodiments of any of the preceding aspects, the gas is air, compressed air, xenon, oxygen, nitrogen, hydrogen, and combinations thereof.

In some embodiments of any of the preceding aspects, the fluid may be a warmed liquid.

In some embodiments of any of the preceding aspects, the liquid is a non-polar or weakly polar and low viscosity liquid.

When the fluid is a liquid, it is generally a non-polar or weakly polar substance and has a relatively low dielectric constant, for example, less than 80 (e.g., less than 79, less than 78, less than 77, less than 76, less than 75, less than 74, less than 73, less than 72, less than 71, less than 70, less than 69, less than 68, less than 67, less than 66, less than 65, less than 64, less than 63, less than 62, less than 61, less than 60, less than 59, less than 58, less than 57, less than 56, less than 55, less than 54, less than 53, less than 52, less than 51, less than 50, less than 49, less than 48, less than 47, less than 46, less than 45, less than 44, less than 43, less than 42, less than 41, less than 40, less than 39, less than 38, less than 37, less than 36, less than 35, less than 34, less than 33, less than 32, less than 31, less than 30, less than 29, less than 28, less than 27, less than 26, less than 25, less than 24, less than 23, less than 22, less than 21, less than 20, less than 19, less than 18, less than 17, less than 16, less than 15, less than 14, less than 13, less than 12, less than 11, less than 10, less than 9, less than 8, less than 7 , less than 6, less than 5, less than 4, less than 3.8, less than 3.5, less than 3, less than 2.7, less than 2.5, or less than 2, etc.), less than 40, less than 10, less than 4.0, less than 3.0, less than 2.5, or less than 2.0, so as to avoid the presence of freely moving ions in solution, and it generally has a relatively low viscosity, for example, less than 80000 mPa·s (e.g., 80000 mPa·s, 70000 mPa·s, 60000 mPa·s, 50000 mPa·s, 40000 mPa·s , 30000 mPa·s, 20000 mPa·s, 10000 mPa·s, 9000 mPa·s, 8000 mPa·s, 7000 mPa·s, 6000 mPa·s, 5000 mPa·s, 4000 mPa·s, 3000 mPa·s , 2000 mPa·s, 1000 mPa·s, 900 mPa·s, 800 mPa·s, 700 mPa·s, 600 mPa·s, 500 mPa·s, 400 mPa·s, 300 mPa·s, 200 mPa·s , 100 mPa·s, 90 mPa·s, 80 mPa·s, 70 mPa·s, 60 mPa·s, 50 mPa·s, 40 mPa·s, 30 mPa·s, 20 mPa·s, 10 mPa·s , 9 mPa·s, 8 mPa·s, 7 mPa·s, 6 mPa·s, 5 mPa·s, 4 mPa·s, 3 mPa·s, 2 mPa·s, 1 mPa·s, 0.9 mPa·s , 0.8 mPa·s, 0.7 mPa·s, 0.6 mPa·s, 0.5 mPa·s, 0.4 mPa·s or 0.3 mPa·s, etc.), less than 8000 mPa·s, less than 800 mPa·s, less than 80 mPa·s, less than 8 mPa·s, or less than 0.8 mPa·s, so as to facilitate the occurrence of the molecular thermal motion.

In some embodiments of any of the preceding aspects, the liquid is selected from the group consisting of dimethyl carbonate, diethyl carbonate, tetrachloroethylene, cyclopentene, n-octane, n-hexane, ethanol, dichloroethane, and combinations thereof.

In some embodiments of any of the preceding aspects, the upper conductive layer and the lower conductive layer comprise a conductive or non-conductive substrate; in some embodiments, the upper conductive layer and the lower conductive layer each independently comprise a material selected from the group consisting of a metal, a carbon material, a semiconductor material, and combinations thereof; in some embodiments, the upper conductive layer and the lower conductive layer each independently comprise a material selected from the group consisting of Au, Pt, Ag, Cu, Zn, ITO, FTO, C, and combinations thereof. When the substrate is a non-conductive substrate, the conductive layer can be obtained by forming the above-mentioned metal, carbon material, and semiconductor material on the substrate.

In some embodiments of any of the preceding aspects, the structures of the upper conductive layer and the lower conductive layer are each independently a nanostructure which is flake or coated with a conductive film layer. In some embodiments of any of the preceding aspects, the nanostructure is a nanogroove, a nanoarray, or a combination thereof.

In some embodiments of any of the preceding aspects, the minimum radial dimension of at least a portion of the cross-section of each of the nano-units in the direction of extension thereof is 1nm-10µm (for example, 1nm, 2nm, 3nm, 4nm, 5nm, 6nm, 7nm, 8nm, 9nm, 10nm, 11nm, 12nm, 13nm, 14nm, 15nm, 16nm, 17nm, 18nm, 19nm, 20nm, 21nm, 22 nm, 24 nm, 28 nm, 30 nm, 32 nm, 35 nm, 38 nm, 40 nm, 50 nm, 60 nm, 70 nm, 80 nm, 90 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 400 nm, 500 nm, 600 nm, 700 nm, 800 nm, 900 nm, 1µm, 2µm, 3µm, 4µm, 5µm, 6µm, 7µm, 8µm, 9µm, or 10µm, etc.), 10nm-1µm, 20nm-300nm, 10nm-500nm, or 10nm-100nm. However, the cross-sectional shape, diameter or length of the piezoelectric material may vary depending on the piezoelectric material itself and the manufacturing process. According to the extension direction of the piezoelectric material, a person skilled in the art can select an appropriate length so that the material with piezoelectric properties when placed in a fluid, may undergo a Brownian motion.

In some embodiments of any of the preceding aspects, the gap between the nano-units in the nano-array is 5nm-20µm(for example, 5 nm, 6 nm, 7 nm, 8 nm, 9 nm, 10 nm, 20 nm, 30 nm, 40 nm, 50 nm, 60 nm, 70 nm, 80 nm, 90 nm, 100 nm, 110 nm, 120 nm, 130 nm, 140 nm, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, 300 nm, 400 nm, 500 nm, 600 nm, 700 nm, 800 nm, 900 nm, 1 µm, 2 µm, 3 µm, 4 µm, 5 µm, 6 µm, 7 µm, 8 µm, 9 µm, or 10 µm), 20nm-5µm, 50nm-1µm, 80nm-500nm, or 100nm-300nm. This space is large enough to make the fluid to be completely filled between the piezoelectric micro-/nano-materials and bend the piezoelectric micro-/nano-materials to create a piezoelectric potential.

In some embodiments of any of the preceding aspects, the piezoelectric micro-/nano-units and the additional micro-/nano-units are each independently nanorods, nanosheets, nanowires, nanobelts, nanotubes, nanohelices, or combinations thereof.

In some embodiments of any of the preceding aspects, the piezoelectric semiconductor micro-/nano-material is selected from hexagonal wurtzite piezoelectric materials.

In some embodiments of any of the preceding aspects, the hexagonal wurtzite piezoelectric materials are selected from the group consisting of ZnO, GaN, ZnS, CdS, InN, InGaN, CdTe, CdSe, ZnSnO₃, and combinations thereof.

In some embodiments of any of the preceding aspects, the perovskite-type piezoelectric materials have a general Formula of ABO₃; wherein A is a rare earth or alkaline earth metal ion, and B is a transition metal ion.

In some embodiments of any of the preceding aspects, the perovskite-type piezoelectric materials are selected from the group consisting of lead zirconate titanate PZT, barium titanate BaTiO₃, potassium sodium niobate KNN, and combinations thereof.

In some embodiments of any of the preceding aspects, the polymer piezoelectric materials are selected from the group consisting of polyvinylidene fluoride PVDF, and polydimethylsiloxane PDMS.

In some embodiments of any of the preceding aspects, the piezoelectric micro-/nano-unit is a ZnO nano-array.

In some embodiments of any of the preceding aspects, the shell material is a metal material having a work function value greater than or less than the work function value of the piezoelectric semiconductor micro-/nano-material.

In some embodiments of any of the preceding aspects, the shell material is other semiconductor material capable of forming a heterojunction with the piezoelectric semiconductor micro-/nano-material.

In some embodiments of any of the preceding aspects, the shell material is a metal material selected from the group consisting of Au, Pt, Ag, Ti, Al, and combinations thereof.

In some embodiments of any of the preceding aspects, the shell material is a semiconductor material selected from the group consisting of CuO, silicon wafer, Cu₂O, NiO, CO₃O₄, and combinations thereof.

In some embodiments of any of the preceding aspects, the shell material is formed by magnetron sputtering, electron beam evaporation, thermal evaporation, or sol-gel of the shell material on the surface of the upper conductive layer on which the nano-units are fixed.

In some embodiments of any of the preceding aspects, the piezoelectric micro-/nano-units, for example, are n-type ZnO nanoarrays, and the shell material is a semiconductor material selected from the group consisting of P-type CuO, P-type silicon wafer, P-type Cu₂O, P-type NiO, P-type Co₃O₄ and combinations thereof.

In yet another aspect, the present application provides an article, apparatus, or power supply device comprising the energy conversion device of the present disclosure. In some embodiments, the article or apparatus is powered by the energy conversion device.

In still another aspect, the present application provides use of the energy conversion device of the present disclosure in energy conversion and collection, for example, energy storage, sensors, wearable devices, and mobile devices.

The inventions of the present application provide one or more of the following advantages:
(1) The energy conversion device of the present invention can convert molecular thermal motion into electrical energy for output.
(2) The energy of the energy conversion device of the present invention is derived from molecular thermal motion which is an abundant and extensive source, and unlike other energy sources, it does not occur many problems during use and can be integrated with a device and achieve stable external electrical energy output.
(3) The energy conversion device of the present invention is environmentally friendly, can be widely applied to power supply devices, and articles and apparatuses that requiring electric power supplied therefrom, and it has a good application prospect.

### EXAMPLES

The following examples are for purposes of illustration only and are not intended to limit the scope of the present application.

### Example 1

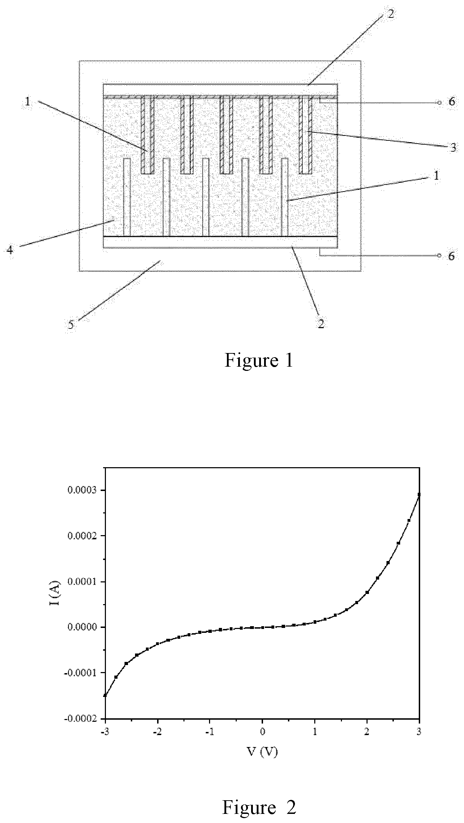

The device of the present invention and the manufacturing method thereof will be described in detail below in combination with Figure 1. The meanings of the reference numerals in Figure 1 are as follows: 1. ZnO piezoelectric nano-array, 2. metal substrate sheet Zn, 3. metal Au film, 4. liquid phase n-octane, 5. encapsulation layer, and 6. lead wire.

### Growth of ZnO nanosheet array by vapor method using ethylenediamine:

A Zn sheet of 3cm×3cm was polished with a metallographic polisher until a mirror effect was achieved, and then was ultrasonicated in ethanol, acetone, and deionized water for 10 minutes in sequence, washed and blown dry with nitrogen gas. A certain amount of an ethylenediamine solution was taken and mixed with deionized water, and then stirred evenly to form a 3.75mol/L ethylenediamine solution. 30mL of the ethylenediamine solution was poured into a weighing bottle, and the Zn sheet was adhered to the inside of the weighing bottle cap, and then the weighing bottle was capped. After the weighing bottle was left at room temperature for 48 h, the Zn sheet was taken out, and the deposits on the surface of the Zn sheet were rinsed with deionized water, and then blown dry with nitrogen gas. A ZnO nanosheet array grown along the C-axis orientation was prepared, it is typically 3.5 µm in height, about 40nm in width, and about 250nm in length.

### Growth of ZnO nanorod array by vapor method using ethylenediamine:

A Zn sheet of 3cm×3cm was polished with a metallographic polisher until a mirror effect was achieved, and then was ultrasonicated in ethanol, acetone, and deionized water for 10 minutes in sequence, washed and blown dry with nitrogen gas. A certain amount of an ethylenediamine solution was taken and mixed with deionized water, and then stirred evenly to form a 3.75mol/L ethylenediamine solution. 30mL of the ethylenediamine solution was poured into a weighing bottle, and the Zn sheet was adhered to the inside of the weighing bottle cap, and then masked. The weighing bottle was capped. After the weighing bottle was left at room temperature for 48 h, the Zn sheet was taken out, and the deposits on the surface of the Zn sheet were rinsed with deionized water, and then blown dry with nitrogen gas. A ZnO nanorod array grown along the C-axis orientation was prepared, it is typically about 2.5 µm in length, and about 60nm in diameter.

### Preparation of upper electrode

An Au film was magnetron sputtered on the surface of the above-mentioned ZnO nanosheet array as an upper electrode.

### Addition of fluid

n-octane (electron grade, purity ≥99.999%) was dropped onto the surface grown with the ZnO nanorod array and the Au-plated surface so that the entire two surfaces were completely filled with the liquid. After a spacer was disposed peripherally on the surface grown with the ZnO nanorod array, the Au-plated surface was inverted onto the spacer upside down, and a certain force was applied onto the Au-plated surface to make it in close contact with the spacer. Wherein the thickness of the spacer after the force was applied is not less than the distance from the free end of the piezoelectric nano-unit (the ZnO nanorod array) to the surface of the lower conductive layer (Zn sheet) on which the piezoelectric nano-unit is fixed, and less than the sum of the distance from the free end of the piezoelectric nano-unit to the surface of the lower conductive layer on which the piezoelectric nano-unit is fixed and the distance from the free end of the Au-plated ZnO nanosheet array to the surface of the upper conductive layer (Zn sheet) on which the ZnO nanosheet array is fixed.

### Encapsulation

The as-prepared entire device with copper wires as lead wires was quickly encapsulated with epoxy resin. After the epoxy resin was dried for 5 hours, and an energy conversion device was obtained.

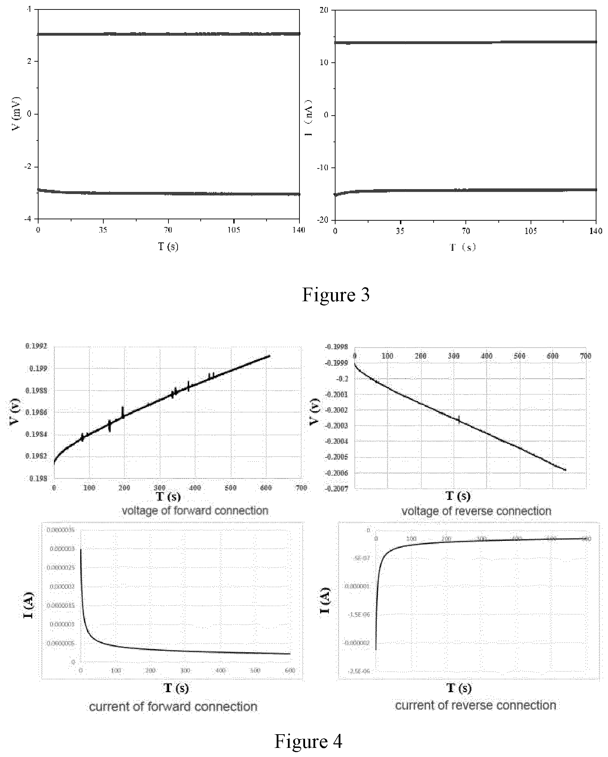

The current-voltage curve of the energy conversion device formed by the method provided in this example at room temperature is shown in Figure 2, which indicates that the device has Schottky characteristics, wherein the Zn sheet was used as a positive electrode, and Au was used as a negative electrode. Figure 3 shows the voltage and current outputs of the energy conversion device at room temperature, indicating that the energy conversion device has good power generation characteristics and can convert the thermal motion of liquid molecules into electrical energy for output.

### Example 2

### Growth of ZnO nanosheet array by vapor method using ethylenediamine:

Zn sheets of 3cmx3cm were ultrasonicated in ethanol, acetone, and deionized water for 10 minutes in sequence, washed and blown dry with nitrogen gas. A certain amount of an ethylenediamine solution was taken and mixed with deionized water, and then stirred evenly to form a 3.75mol/L ethylenediamine solution. 30mL of the ethylenediamine solution was poured into weighing bottles, and then the Zn sheets were hanged over the solution in the weighing bottles and then the weighing bottles were sealed. After the weighing bottles were left at room temperature for 48 h, the Zn sheets were taken out, and the deposits on the surface of the sheets were rinsed with deionized water, and then blown dry with nitrogen gas. ZnO nanosheet arrays grown along the C-axis orientation were obtained, they are typically 3.5 µm in height, 40nm in width, and 250nm in length.

### Preparation of upper electrode

An Au film was magnetron sputtered on the surface of the above-mentioned ZnO array as an upper electrode.

### Addition of fluid

Dimethyl carbonate was dropped onto the surface grown with the ZnO array and the Au-plated surface so that the entire two surfaces were completely filled with the liquid. After a spacer was disposed peripherally on the surface grown with the ZnO array, the Au-plated surface was inverted onto the spacer upside down, and a certain force was applied onto the Au-plated surface to make it in close contact with the spacer.

### Encapsulation

The as-prepared entire device with copper wires as lead wires was quickly encapsulated with epoxy resin. After the epoxy resin was dried for 5 hours, an energy conversion device was obtained.

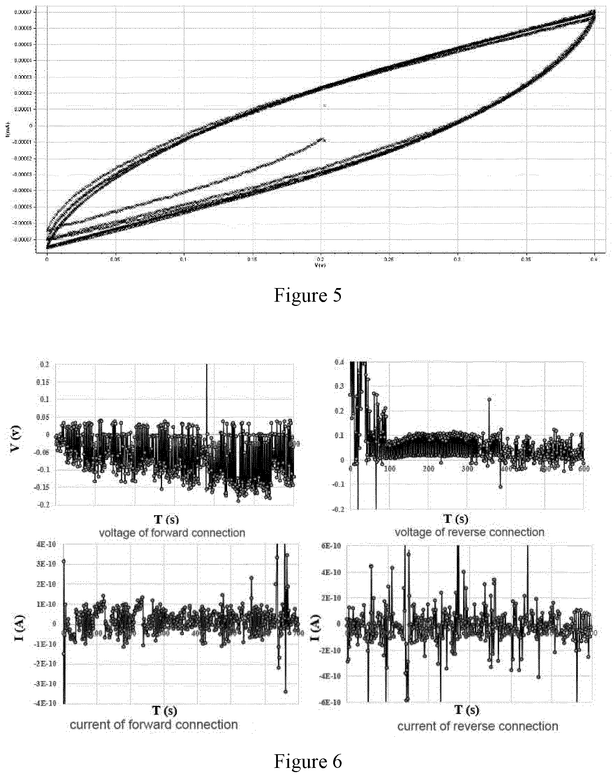

Figure 4 shows the current and voltage output curves of the device of this example at room temperature. Figure 5 shows the cyclic voltammetry curve of the device, which indicates that the device exhibits electric double-layer capacitance behavior, and its output value may be a superposition of the capacitance effect and the piezoelectric effect.

### Example 3

### Growth of ZnO nanosheet array by vapor method using ethylenediamine:

Zn sheets of 3cmx3cm were ultrasonicated in ethanol, acetone, and deionized water for 10 minutes in sequence, washed and blown dry with nitrogen gas. A certain amount of an ethylenediamine solution was taken and mixed with deionized water, and then stirred evenly to form a 3.75mol/L ethylenediamine solution. 30mL of the ethylenediamine solution was poured into weighing bottles, and then the Zn sheets were hanged over the solution in the weighing bottles and then the weighing bottles were sealed. After the weighing bottles were left at room temperature for 48 h, the Zn sheets were taken out, and the deposits on the surface of the sheets were rinsed with deionized water, and then blown dry with nitrogen gas. ZnO nanosheet arrays grown along the C-axis orientation were prepared, they are typically 3.5 µm in height, about 40nm in width, and about 250nm in length.

### Preparation of upper electrode

An Au film was magnetron sputtered on the surface of the above-mentioned ZnO array as an upper electrode.

### Encapsulation

After a spacer was disposed peripherally on the surface grown with the ZnO array, the Au-plated surface was inverted onto the spacer upside down, and a certain force was applied onto the Au-plated surface to make it in close contact with the spacer. The as-prepared entire device with copper wires as lead wires was quickly encapsulated with epoxy resin under vacuum condition. After the epoxy resin was dried for 5 hours, an energy conversion device was obtained.

Figure 6 shows the current and voltage output curves of the device of this example at room temperature. No effective electrical energy output was detected for the device of Example 3 without an encapsulated fluid.

### Example 4

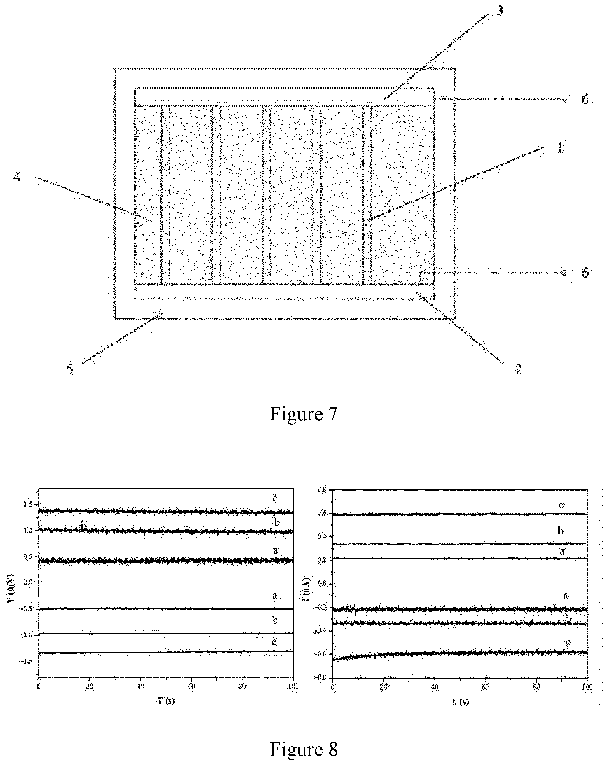

The device of the present invention and the manufacturing method thereof will be described in detail below in combination with Figure 7. The meanings of the reference numerals in Figure 7 are as follows: 1. BaTiO₃ nanorod array, 2. FTO substrate sheet, 3. aluminum foil, 4. liquid phase n-octane, 5. encapsulation layer, 6. lead wire.

### First step: hydrothermal synthesis of TiCh nanoarray

FTO of 3cm×3cm×2.2 mm was ultrasonicated in a mixed solution of distilled water, acetone and isopropanol in a volume ratio of 1:1:1 for 30 min, and then rinsed with methanol and distilled water. The FTO was placed vertically in a reaction kettle containing a mixed solution of 10 mL of distilled water, 10 mL of hydrochloric acid (concentration of 37%), and 1 mL of titanium isopropoxide, and then the reaction kettle was sealed. The reaction kettle was placed in an oven at 200°C for 3 h. After completion of the reaction, The FTO was taken out, cooled to room temperature, rinsed with distilled water, and then blown dry with nitrogen gas.

### Second step: hydrothermal synthesis of BaTiO₃ nanoarray

The above-mentioned substrate sheet was placed in a reaction kettle containing a Ba(OH)₂·8H₂O solution at 170°C for 8 h. After completion of the reaction, the substrate sheet was taken out, cooled to room temperature, rinsed with distilled water, and then air-dried at room temperature. The TiO₂ nanoarray grown on the FTO was converted into a BaTiO₃ nanoarray, which was then left at 600°C for 30 minutes to reduce defects. The grown BaTiO₃ nanorods were about 1µm in length and about 90nm in diameter.

### Polarization of device

An aluminum foil was covered onto the FTO grown with the BaTiO₃ nanorod array and used as an upper electrode, the conductive surface of the FTO was used as a lower electrode, and copper foils used as lead wires. A DC voltage of 120KV/cm was applied between the two electrodes and left for 24 hours.

### Encapsulation of device

n-octane was added dropwise between the two upper and lower electrodes so that the upper and lower surfaces opposite to each other were completely filled with n-octane. Then the entire device was encapsulated with epoxy resin.

### Example 5

Molecular thermal motion, as an energy source for thermal motion generators, has a kinetic energy proportional to the absolute temperature. Theoretically, the higher the temperature, the more intense the molecule thermal motion of the fluid such as n-octane, the more intense the driven Brownian motion of the ZnO nanoarray, and the greater the deformation that occurs.

The output performances of the device under different temperature environments were tested below in combination with Figure 1.

### Experimental temperature control

Experimental temperature conditions were obtained using a water bath method, and a temperature sensor were placed in thermal preservation systems to monitor the temperature in real time. Three temperature points (from low to high): -13.3°C, -0.4°C, and 9.8°C, were chosen. Among them, -13.3 °C was achieved using an ice salt bath and the remaining temperature points were achieved by mixing ice with cold/hot water. Addtionally, the thermal preservation effect of the thermal preservation systems was monitored for 1 hour, and the variation values of temperatures in the thermal preservation systems at different temperatures were all less than 2°C, which was considered to be within an acceptable range.

### Test of output performances at different temperatures

The same well-encapsulated device (which was prepared according to the preparation method described in Example 1) was successively placed in the thermal preservation systems at different temperatures from low to high, and after standing for 10 minutes, its current and voltage outputs were tested.

Figure 8 shows the voltage and current outputs of the energy conversion device at different temperatures, and curves a, b and c in Figure 8 respectively correspond to the output performances of the energy conversion device at the above-mentioned different temperatures of -13.3°C, -0.4°C and 9.8°C. As assumed, the output current and voltage of the generator increase continuously with the increased temperature. The current and voltage outputs exhibit the linear superposition effect, and other disturbances caused by the test system were excluded. The experimental results further verify that the output of the thermal motion generator is indeed related to the molecular thermal motion.

While the present invention has been described in detail with reference to the general description and specific embodiments, it will be apparent to those skilled in the art that modifications or improvements may be made thereto and that any combination thereof may be made as desired. Accordingly, such modifications and improvements made without departing from the spirit of the present invention fall within the claimed scope of the present invention.

## Claims

1. An energy conversion device of formula I comprising:
an upper conductive layer;
a lower conductive layer disposed beneath the upper conductive layer;
at least one piezoelectric micro-/nano-unit and a fluid disposed between the upper conductive layer and the lower conductive layer;
wherein the piezoelectric micro-/nano-unit has piezoelectric properties and is immersed in the fluid.

2. The energy conversion device according to claim 1, wherein:
one end of the piezoelectric micro-/nano-unit is fixed on the surface of the lower conductive layer facing the upper conductive layer, and the other end of the piezoelectric micro-/nano-unit is in contact with the upper conductive layer; or
the upper conductive layer covers onto the surface of the lower conductive layer on which the piezoelectric micro-/nano-unit is fixed;
optionally, the piezoelectric micro-/nano-unit comprises or is composed of a piezoelectric micro-/nano-material selected from the group consisting of hexagonal wurtzite piezoelectric materials, perovskite-type piezoelectric materials, polymer piezoelectric materials, and combinations thereof.

3. The energy conversion device according to claim 1, further comprising at least one additional micro-/nano-unit, one end of the piezoelectric micro-/nano-unit is fixed on the surface of the lower conductive layer facing the upper conductive layer, one end of the additional micro-/nano-unit is fixed on the surface of the upper conductive layer facing the lower conductive layer, and the other end of the piezoelectric micro-/nano-unit is a free end such that the piezoelectric micro-/nano-unit, when randomly vibrating, may contact with the additional micro-/nano-unit, wherein the other end of the additional micro/nano unit is optionally a free end,
wherein the additional micro-/nano-unit satisfies at least one of the following conditions (i) and (ii):
(i) the additional micro-/nano-unit comprises or is composed of a material capable of forming a Schottky junction or heterojunction with the piezoelectric micro-/nano-unit;
(ii) the surfaces of the additional micro-/nano-unit is coated with a shell material which is a material capable of forming a Schottky junction or a heterojunction with the piezoelectric micro-/nano-unit;
optionally, the piezoelectric micro-/nano-units on the surface of the lower conductive layer form a cross-finger structure with the additional micro-/nano-units on the surface of the upper conductive layer;
optionally, the micro-/nano-material in the additional micro-/nano-unit is the same as or different from the piezoelectric micro-/nano-material in the piezoelectric micro-/nano-unit;
optionally, when the micro-/nano-material in the additional micro-/nano-unit is the same as the piezoelectric micro-/nano-material in the piezoelectric micro-/nano-unit, the surfaces of the additional micro-/nano-unit is coated with the shell material;
optionally, the additional micro-/nano-unit is a non-piezoelectric micro-/nano-unit;
optionally, the piezoelectric micro-/nano-unit comprise or is composed of a piezoelectric semiconductor micro-/nano-material.

4. The energy conversion device according to claim 1, wherein the at least one piezoelectric micro-/nano-unit refers to two or more piezoelectric micro-/nano-units, the two surfaces of the upper and the lower conductive layers opposite to each other are fixed with one ends of the piezoelectric micro-/nano-units, and the other end of each of the piezoelectric micro-/nano-units on at least one of said two surfaces of the upper and lower conductive layers is a free end such that the piezoelectric micro-/nano-units having the free end on the at least one of the conductive layers, when randomly vibrating, may contact with the piezoelectric micro-/nano-units on the opposite other conductive layer;
wherein the surfaces of the piezoelectric micro-/nano-units on the surface of the upper conductive layer or the surfaces of the piezoelectric micro-/nano-units on the surface of the lower conductive layer are coated with a shell material which is a material capable of forming a Schottky junction or a heterojunction with the piezoelectric micro-/nano-units;
optionally, the piezoelectric micro-/nano-units on the surface of the upper conductive layer form a cross-finger structure with the piezoelectric micro-/nano-units on the surface of the lower conductive layer;
optionally, the piezoelectric micro-/nano-units comprise or are composed of a piezoelectric semiconductor micro-/nano-material.

5. A method for manufacturing an energy conversion device, comprising:
providing an upper conductive layer;
providing a lower conductive layer and disposing it beneath the upper conductive layer;
disposing at least one piezoelectric micro-/nano-unit and a fluid between the upper conductive layer and the lower conductive layer; and
immersing the piezoelectric micro-/nano-unit in the fluid.

6. The method according to claim 5, further comprising:
a fixing step: fixing one end of the piezoelectric micro-/nano-unit on a surface of the lower conductive layer; optionally, the fixing step comprises growing the piezoelectric micro-/nano-unit on the surface of the lower conductive layer; optionally, said growth refers to growing along an orientation perpendicular to the surface of the conductive layer;
an assembling step: contacting the other end of the fixed piezoelectric micro-/nano-unit with the upper conductive layer; optionally, the assembling step comprises covering the upper conductive layer onto the surface of the lower conductive layer on which the piezoelectric micro-/nano-unit is grown;
a fluid introducing step: introducing the fluid optionally before, after or during the assembling step; optionally, the fluid introducing step comprises introducing the fluid to the surface of the lower conductive layer on which the piezoelectric micro-/nano-unit is fixed before the assembling step; optionally, the fluid introducing step comprises introducing the fluid between the upper conductive layer and the lower conductive layer after the assembling step; optionally, the fluid introducing step comprises conducting the assembly step in an atmosphere of the fluid as a gas to introduce the fluid during the assembling process; optionally, the fluid introducing step comprises introducing the liquid between the upper conductive layer and the lower conductive layer after the assembling step;
optionally, the method further comprises a device encapsulation step; optionally, the device encapsulation step comprises physical or chemical encapsulation, and optionally, the encapsulation is a mechanical encapsulation, or encapsulation using an adhesive or tape.
optionally, the piezoelectric micro-/nano-unit comprises or is composed of a piezoelectric micro-/nano-material selected from the group consisting of hexagonal wurtzite piezoelectric materials, perovskite-type piezoelectric materials, polymer piezoelectric materials, and combinations thereof;
optionally, when the piezoelectric micro-/nano-unit comprises a piezoelectric micro-/nano-material selected from the group consisting of perovskite-type piezoelectric materials, polymer piezoelectric materials, and combinations thereof, polarizing the device before the fluid introducing step; optionally, the polarizing step comprises applying an electric field between the upper conductive layer and the lower conductive layer to spontaneously polarize the device under the electric field such that the piezoelectric micro-/nano-unit is preferentially oriented along the direction of the electric field.

7. The method according to claim 5, wherein the device further comprises an additional micro-/nano-unit, wherein the additional micro-/nano-unit satisfies at least one of the following conditions (i) and (ii):
(i) the additional micro-/nano-unit comprises or is composed of a material capable of forming a Schottky junction or heterojunction with the piezoelectric micro-/nano-unit;
(ii) the surfaces of the additional micro-/nano-unit is coated with a shell material which is a material capable of forming a Schottky junction or a heterojunction with the piezoelectric micro-/nano-unit;
said method further comprises:
a fixing step: fixing one end of the piezoelectric micro-/nano-unit on the surface of the lower conductive layer, and fixing one end of the additional micro-/nano-unit on the surface of the upper conductive layer, and the other end of the piezoelectric micro-/nano-unit is a free end, the other end of the additional micro-/nano-unit is optionally a free end; optionally, the fixing step comprises growing the additional micro-/nano-unit and the piezoelectric micro-/nano-unit on the surface of the upper conductive layer and the surface of the lower conductive layer, respectively; optionally, said growth refers to growing along an orientation perpendicular to the surface of the conductive layer;
an optional coating step: coating the shell material on the surface of the additional micro-/nano-unit when the additional micro-/nano-unit does not satisfy the above condition (i); wherein the shell material is a material capable of forming a Schottky junction or a heterojunction with the piezoelectric micro-/nano-unit;
an assembling step: assembling in such a manner that the surface of the lower conductive layer on which the piezoelectric micro-/nano-unit is fixed and the surface of the upper conductive layer on which the additional micro-/nano-unit is fixed face each other, so that the piezoelectric micro-/nano-unit, when randomly vibrating, may contact with the additional micro-/nano-unit; wherein when the additional micro/nano cell does not satisfy the above condition (i), the upper conductive layer to which the additional micro-/nano-unit is fixed is the upper conductive layer to which the additional micro-/nano-unit coated with the shell material is fixed;
optionally, the assembling step comprises: disposing peripherally a spacer on the surface of the lower conductive layer on which the piezoelectric micro-/nano-unit is fixed, wherein the thickness of the spacer or the thickness of the compressed spacer when the spacer is compressed due to a force is not less than the distance from the free end of the piezoelectric micro-/nano-unit to the surface of the lower conductive layer on which the piezoelectric micro-/nano-unit is fixed, and less than the sum of the distance from the free end of the piezoelectric micro-/nano-unit to the surface of the lower conductive layer on which the piezoelectric micro-/nano-unit is fixed and the distance from the free end of the additional micro-/nano-unit to the surface of the upper conductive layer on which the additional micro-/nano-unit is fixed; and placing the upper conductive layer, on which the additional micro/nano unit is fixed, on the spacer;
a fluid introducing step: introducing the fluid optionally before or during the assembling step step; optionally, the fluid introducing step comprises introducing the fluid to the surface of the lower conductive layer on which the piezoelectric micro-/nano-unit is fixed and the surface of the upper conductive layer on which the additional micro-/nano-unit is fixed before the assembling step; optionally, the fluid introducing step comprises introducing the fluid as a liquid into the space surrounded by the entire spacer after disposing the spacer, and then placing the upper conductive layer on which the additional micro-/nano-unit is fixed on the spacer to introduce the fluid during the assembling process; wherein when the additional micro-/nano-unit does not satisfy the above condition (i), the surface of the upper conductive layer on which the additional micro-/nano-unit is fixed is the surface of the upper conductive layer to which the additional micro-/nano-unit coated with the shell material is fixed; optionally, the fluid introducing step comprises conducting the assembling step in an atmosphere of the fluid as a gas to introduce the fluid during the assembling process;
optionally, the method further comprises a device encapsulation step; optionally, the device encapsulation step comprises physical or chemical encapsulation, and optionally, the encapsulation is a mechanical encapsulation, or encapsulation using an adhesive or tape;
optionally, the assembling is performed in such a manner that the additional micro-/nano-units on the surface of the upper conductive layer form a cross-finger structure with the piezoelectric micro-/nano-units on the surface of the lower conductive layer;
optionally, the micro-/nano-material in the additional micro-/nano-unit is the same as or different from the piezoelectric micro-/nano-material in the piezoelectric micro-/nano-unit;
optionally, when the micro-/nano-material in the additional micro-/nano-unit is the same as the piezoelectric micro-/nano-material in the piezoelectric micro-/nano-unit, the surfaces of the additional micro-/nano-unit is coated with the shell material;
optionally, the additional micro-/nano-unit is a non-piezoelectric micro-/nano-unit;
optionally, the piezoelectric micro-/nano-unit comprise or is composed of a piezoelectric semiconductor micro-/nano-material.

8. The energy conversion device according to any one of claims 1 to 4, or the method according to any one of claims 5 to 7, wherein the two surfaces of the upper and lower conductive layers opposite each other are substantially parallel;
optionally, the micro-/nano-unit at each occurrence is a micro/nanometer array;
optionally, the piezoelectric micro-/nano-unit and the additional micro-/nano-unit are each at least partially or completely immersed in the fluid;
optionally, the space between the two surfaces of the upper and lower conductive layers opposite each other is at least partially or completely filled with the fluid;
optionally, the fixing refers to fixing along an orientation perpendicular to the surface of the conductive layer;
optionally, the energy conversion device further comprises an encapsulation layer; the encapsulation layer is provided on the outer periphery of the device; optionally, the encapsulation layer comprises an adhesive; optionally, the adhesive is selected from the group consisting of epoxy resins, silicones, EVA, and combinations thereof;
optionally, the energy conversion device further comprises lead wires; the lead wires are led out from the upper conductive layer and the lower conductive layer respectively;
optionally, the fluid is a gas or a liquid;
optionally, the gas is a compressed and/or warmed gas;
optionally, the gas is a heavy molecular gas; optionally, the gas is a compressed and/or warmed heavy molecular gas;
optionally, the gas is air, compressed air, xenon, oxygen, nitrogen, hydrogen, and combinations thereof;
optionally, the fluid is a warmed liquid;
optionally, the dielectric constant of the liquid is less than 80, less than 40, less than 10, less than 4.0, less than 3.0, less than 2.5, or less than 2.0;
optionally, the viscosity of the liquid is less than 80000 mPa·s, less than 8000 mPa·s, less than 800 mPa·s, less than 80 mPa·s, less than 8 mPa·s, or less than 0.8 mPa·s;
optionally, the liquid is a non-polar or weakly polar liquid;
optionally, the liquid is a low viscosity liquid;
optionally, the liquid is a non-polar or weakly polar and low viscosity liquid;
optionally, the liquid is selected from the group consisting of dimethyl carbonate, diethyl carbonate, tetrachloroethylene, cyclopentene, n-octane, n-hexane, ethanol, dichloroethane, and combinations thereof;
optionally, the upper conductive layer and the lower conductive layer comprise a conductive or non-conductive substrate; optionally the upper conductive layer and the lower conductive layer each independently comprise a material selected from the group consisting of a metal, a carbon material, a semiconductor material, and combinations thereof; optionally, the upper conductive layer and the lower conductive layer each independently comprise a material selected from the group consisting of Au, Pt, Ag, Cu, Zn, ITO, FTO, C, and combinations thereof;
optionally, the structures of the upper conductive layer and the lower conductive layer are each independently a nanostructure which is flake or coated with a conductive film layer; optionally, the nanostructure is a nanogroove, a nanoarray, or a combination thereof;
optionally, the minimum radial dimension of at least a portion of the cross-section of each of the nano-units in the direction of extension thereof is 1nm-10µm, 10nm-1µm, 20nm-300nm, 10nm-500nm, or 10nm-100nm;
optionally, the gap between the nano-units in the nano-array is 5nm-20µm, 20nm-5µm, 50nm-1µm, 80nm-500nm, or 100nm-300nm;
optionally, the piezoelectric micro-/nano-units and the additional micro-/nano-units are each independently nanorods, nanosheets, nanowires, nanobelts, nanotubes, nanohelices, or combinations thereof;
optionally, the piezoelectric semiconductor micro-/nano-material is selected from hexagonal wurtzite piezoelectric materials;
optionally, the hexagonal wurtzite piezoelectric materials are selected from the group consisting of ZnO, GaN, ZnS, CdS, InN, InGaN, CdTe, CdSe, ZnSnO₃, and combinations thereof;
optionally, the perovskite-type piezoelectric materials have a general Formula of ABO₃; wherein A is a rare earth or alkaline earth metal ion, and B is a transition metal ion;
optionally, the perovskite-type piezoelectric materials are selected from the group consisting of lead zirconate titanate PZT, barium titanate BaTiO₃, potassium sodium niobate KNN, and combinations thereof;
optionally, the polymer piezoelectric materials are selected from the group consisting of polyvinylidene fluoride PVDF, and polydimethylsiloxane PDMS;
optionally, the piezoelectric micro-/nano-unit is a ZnO nano-array;
optionally, the shell material is a metal material having a work function value greater than or less than the work function value of the piezoelectric semiconductor micro-/nano-material;
optionally, the shell material is other semiconductor material capable of forming a heterojunction with the piezoelectric semiconductor micro-/nano-material;
optionally, the shell material is a metal material selected from the group consisting of Au, Pt, Ag, Ti, Al, C, and combinations thereof;
optionally, the shell material is a semiconductor material selected from the group consisting of CuO, silicon wafer, Cu₂O, NiO, Co₃O₄, and combinations thereof;
optionally, the shell material is formed by magnetron sputtering, electron beam evaporation, thermal evaporation, or sol-gel of the shell material on the surface of the upper conductive layer on which the nano-units are fixed.

9. An article, apparatus, or power supply device comprising the energy conversion device of any one of claims 1 to 4 and 8, optionally, the article or apparatus is powered by the energy conversion device.

10. Use of the energy conversion device of any one of claims 1 to 4 and 8 in energy conversion and collection, for example, energy storage, sensors, wearable devices, and mobile devices.
